# EUROPEAN PATENT APPLICATION

(11) **EP 2 597 130 A1**
(43) Date of publication of application: **29.05.2013**
(21) Application number: 11809614.8
(22) Date of filing: 15.07.2011
(51) Int. Cl.: C09K 11/64, C09K 11/08, H01L 33/50

(54) **BETA-TYPE SIALON, PROCESS FOR PRODUCTION OF ß-TYPE SIALON, AND LIGHT-EMITTING DEVICE**

(30) Priority: 20.07.2010 JP 2010163277
(71) Applicant: Denki Kagaku Kogyo Kabushiki Kaisha, Tokyo 103-8338 (JP)
(72) Inventor: HASHIMOTO Hisayuki, Machida-city Tokyo 194-8560 (JP); YAMADA Suzuya, Machida-city Tokyo 194-8560 (JP); EMOTO Hideyuki, Machida-city Tokyo 194-8560 (JP); ICHIKAWA Masayoshi, Machida-city Tokyo 194-8560 (JP)
(74) Representative: Gulde Hengelhaupt Ziebig & Schneider
(86) International application number: PCT/JP2011/066227
(87) International publication number: WO 2012/011444

(57) **Abstract**

A method for manufacturing β-sialon, including: a mixing process wherein at least one of aluminum oxide and silicon oxide, silicon nitride, aluminum nitride, and europium compound are mixed; a burning process wherein the mixture having undergone the mixing process is heated at the temperature hither than 1950°C but not exceeding 2200°C for 10 hours or longer; and a heat treatment process wherein heat treatment is conducted after the burning process at the temperature from 1300°C to 1600°C in an atmosphere of inert gas other than nitrogen at the partial pressure of 10 kPa or lower.

## Description

### Technical Field

The present invention relates to β-sialon, a method for manufacturing the β-sialon, and a light-emitting device.

### Background Art

A phosphor formed Eu²⁺ into β-sialon crystal structure is excited by ultraviolet to blue light and emits 520 to 550-nm green light. The β-sialon contained Eu²⁺ in a form of solid solution is also called Eu doped β-sialon. This phosphor is used as a green light-emitting component of light-emitting devices such as white light-emitting diode (referred to as white LED). The Eu doped β-sialon has very sharp emission spectra, of the phosphors with Eu²⁺ contained therein in a form of solid solution, and is suitable as a green light-emitting component of the light source of backlight of liquid display panels, in particular, for which narrow-band emission of three primary colors, namely blue, green, and red, is required (Patent Literature 1).

### Citation List

### Patent Literature

Patent Literature 1: JP 2005-255895A

### Non-patent Literature

Non-patent Literature 1: Kazuaki Okubo et al., Measurement of quantum efficiency of NBS standard phosphors, Journal of the Illuminating Engineering Institute of Japan, Vol. 83, No. 2, pp.87-93, 1999

### Summary of Invention

### Solution to Problem

With the progress of practical application of the Eu doped β-sialon, improvement of emission efficiency is desired.

The first objective of the present invention is to provide Eu doped β-sialon capable of achieving high emission efficiency and a method of manufacturing the same, and the second objective is to provide a light-emitting device capable of emitting light highly efficiently.

### Means for Solving the Problems

To achieve the first objective, the present invention is Eu doped β-sialon represented by a general formula Si_{6-z}Al_{z}O_{z}N_{8-z} (0<z≤0.42), wherein Eu is contained in, and the 50% mean area diameter of the primary particles of the Eu doped β-sialon is 5 µm or larger.

The 50% mean area diameter of the primary particles of the β-sialon of the present invention is desirably 7 µm or larger. Furthermore, it is desirable that the median diameter (hereinafter referred to as D50 particle diameter) of the secondary particle distribution of the β-sialon is 30 µm or smaller.

The β-sialon of the present invention can be obtained by allowing β-sialon raw materials, namely a mixture of at least one of aluminum oxide and silicon oxide, silicon nitride, aluminum nitride, and europium compound, to undergo a burning process to be heated at the temperature higher than 1950°C but not exceeding 2200°C for 10 hours or longer. It is preferable that the pressure condition for burning is from 0.5 MPa to 10 MPa.

The light-emitting device to achieve the second objective includes a luminescent light source and a wavelength converting member, the wavelength converting member includes a phosphor for absorbing near-ultraviolet to blue light generated by the luminescent light source and generating fluorescent light, the phosphor is Eu doped β-sialon wherein Eu is contained in β-sialon represented by general formula Si_{6-z}Al_{z}O_{z}N_{8-z} (0<z≤0.42), and the 50% mean area diameter of the primary particles of the Eu doped β-sialon is 5 µm or larger.

As a luminescent light source of the light-emitting device, an LED chip generating light having wavelength falling within a range from 350 nm to 500 nm is desirable.

It is preferable that the phosphor further contains Eu doped α-sialon.
Ca-α-sialon is desirable as Eu doped α-sialon.

### Advantageous Effect of Invention

By the β-sialon or the method of manufacturing the β-sialon according to the present invention, Eu doped β-sialon having high emission efficiency can be provided.

Since the light-emitting device of the present invention uses the β-sialon capable of achieving high emission efficiency, a high-brightness light-emitting device can be provided.

### Brief Description of Drawings

FIG. 1 is a pattern diagram illustrating the structure of a measuring device for the EBSD method.
FIG. 2 is a cross-sectional view illustrating the structure of the light-emitting device of the present invention.
FIG. 3 is a scanning electron microscopic (SEM) image of the β-sialon in Example 1.
FIG. 4 is EBSD images of the β-sialon shown in FIG. 3 by the EBSD method, wherein (A) is an EBSD image and (B) is an explanatory drawing of (A).
FIG. 5 is an SEM image of the β-sialon in Example 1.
FIG. 6 is EBSD images of the β-sialon shown in FIG. 5, wherein (A) is an EBSD image and (B) is an explanatory drawing of (A).

### Description of Embodiments

The embodiments of the present invention will hereinafter be described in detail by referring to drawings.

### (β-sialon)

The β-sialon according to the embodiment of the present invention is represented by general formula Si_{6-z}Al_{z}O_{z}N_{8-z}: Eu (0<z≤0.42), and is a phosphor made of Eu²⁺ doped β-sialon. Hereinafter, the Eu²⁺ doped β-sialon is referred to as the β-sialon simply.

In the general formula Si_{6-z}Al_{z}O_{z}N_{8-z}: Eu, z is made to be larger than 0 but not exceeding 0.42 to achieve high emission intensity.

The β-sialon is formed with a plurality of particles solidly integrated into one when heating is performed in the burning process, and each of the plurality of particles is called a primary particle, whereas the one formed with the plurality of particles solidly integrated is called a secondary particle.
The inventors acquired the knowledge that the 50% mean area diameter of the primary particles affects the emission intensity, and found that to improve the emission intensity of the β-sialon, it is necessary to keep only the 50% mean area diameter of the primary particles at 5 µm or larger, more preferably, 7 µm or larger.

The 50% mean area diameter of the primary particles will be described below.
Individual primary particles of the β-sialon, namely monocrystal particles, include particles having a cross-sectional area CA1, CA2, CA3, ... CAi, ...CAk, in the order from small to large. A cumulative curve was found with the total area (CA1+CA2+CA3+...+CAi+...+CAk) of the aggregation of these primary particles regarded as 100%, and the diameter of the primary particle calculated from the area of the primary particle at the point where the cumulative curve hits 50% was regarded as the 50% mean area diameter.

The method of measuring the 50% mean area diameter of the primary particles will be described below.
The 50% mean area diameter of the primary particles can be measured by the electron backscatter diffraction (EBSD) method.

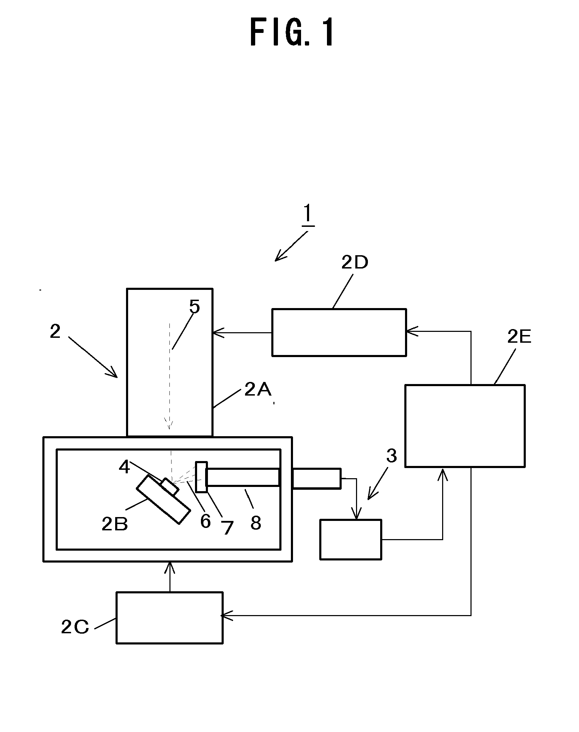

FIG. 1 is a pattern diagram illustrating the structure of a device used for measurement by the EBSD method.
As shown in FIG. 1, the device 1 used for the EBSD method is structured by adding an electronic backscatter diffraction pattern measuring instrument 3 to a scanning electron microscope 2. The scanning electron microscope 2 includes a lens tube 2A, a stage 2B on which a sample 4 is placed, a stage control unit 2C, electron scanning unit 2D, and a control computer 2E. The electron backscatter diffraction pattern measuring instrument 3 includes a fluorescent screen 7 for detecting electrons 6 generated and backscattered as a result of irradiation of electron beams 5 to the sample 4, a camera 8 for shooting this fluorescent image on the fluorescent screen 7, software for fetching, and analyzing electron backscatter diffraction image (not shown) data.

The measurement by the EBSD method will be described below.
Electron beams are irradiated to the β-sialon to cause electron scattering corresponding to a crystal structure and crystal plane to occur, and the shape of this electron scattering pattern is analyzed. Specifically, crystal orientation of individual particles of phosphor are identified, the images of particle diameter in individual crystal orientation are analyzed, and the 50% mean area diameter of primary particles is calculated using formula (1) shown below.
50% mean area diameter of primary particles = 2 × (S/π)^{1/2} (1)
S in the formula is the area of the primary particle at the 50% point on the cumulative curve representing the area of individual primary particles.

If the 50% mean area diameter of primary particles is small, impurities existing in crystalline boundary tend to increase, and in addition, crystallinity tends to decrease. Consequently, emission efficiency tends to decrease. It is desirable that the 50% mean area diameter of the primary particles is 5 µm or larger, more preferably 7 µm or larger. The 50% mean area diameter of the primary particles can be controlled by controlling the composition of powder raw materials, and the temperature and duration time of heating treatment during the burning process. The upper limit of the 50% mean area diameter of the primary particles is determined naturally depending on the upper limit of the size of secondary particles, which will be described later.

In other words, to improve the emission intensity of the β-sialon, it is desirable that the 50% mean area diameter of the primary particles of the β-sialon be 5 µm or larger, more preferably 7 µm or larger, and furthermore, the D50 particle diameter of the secondary particles of the β-sialon is 30 µm or smaller.

It is desirable that the D50 particle diameter of the secondary particles of the β-sialon is 30 µm or smaller, more preferably 25 µm or smaller.
If the D50 particle diameter of the secondary particles of the β-sialon is large, the state of dispersion in resin degrades when applied to light-emitting devices such as white LED, causing degradation in brightness and unevenness of color. Meanwhile, if the D50 particle diameter of the secondary particles of the β-sialon is small, degradation in emission efficiency of phosphor itself or decrease in brightness of light-emitting devices due to scattering of light tend to occur.

The lower limit of D50 particle diameter is affected by the size of primary particles, but the D50 particle diameter of the secondary particles can be adjusted by conducting crashing, classification, or combination of both.

Since the β-sialon of the present invention is excited in a wide wavelength range from ultraviolet to visible light, and emits green light having main wavelength that falls within a range from 520 nm to 550 nm, it is excellent as a phosphor emitting green light. It is therefore possible to use the β-sialon of the present invention favorably for various light-emitting devices, for white LED using an ultraviolet and blue LED chips as a light source in particular, by itself or in combination with other phosphors.

(Method of manufacturing the β-sialon)
The method of manufacturing the β-sialon of the present invention includes a burning process and a heat treatment process. In the burning process, the raw material is placed in an environment where the temperature is higher than 1950°C but not exceeding 2200°C for 10 hours or longer, and in the heat treatment process the number of electrons excited by external excitation light (electron trap for collecting excited electrons) in the host crystals of the β-sialon having undergone the burning process is decreased. It is desirable that an acid treatment process for improving quality and a process of removing suspended matter having low specific gravity be added after the heat treatment process.

The burning process of the β-sialon will be described below.
Constituent elements of the β-sialon, namely raw materials including Si, Al, N, O, and Eu, are mixed, and the obtained mixed composition is used as raw material mixture. The raw material mixture includes the one containing silicon nitride (Si₃N₄), aluminum nitride (AlN), silicon oxide (SiO₂) and/or aluminum oxide (Al₂O₃), and the one further containing an Eu compound selected from Eu metal, oxide, carbonate, nitride and oxynitride.

Powder raw material mixture is filled in a container whose surface contacting the raw material is made of boron nitride, such as crucible, and heated in an atmosphere of nitrogen, etc., thereby promoting solid solution reaction and obtaining the β-sialon. From the viewpoint of suppressing interparticle sintering during the solid solution reaction, it is desirable that the powder raw material mixture is filled in a container at the volume density of 0.8 g/cm³ or lower.

The conditions of the burning process is as follows: burning temperature; higher than 1950°C but not exceeding 2200°C, burning time; 10 hours or longer. By allowing the burning conditions to fall within the range described above, β-sialon wherein the 50% mean area diameter of the primary particles is 5 µm or larger can be obtained, and therefore the β-sialon having high emission intensity can be produced.

To adjust the 50% mean area diameter of the primary particles, the burning temperature and burning time in the burning process were specified. It is desirable that burning be conducted under the pressure condition from 0.5 MPa to 10 MPa.

The 50% mean area diameter of the primary particles can be controlled even after the burning process by heat treatment of the β-sialon having undergone the burning process in a nitrogen gas atmosphere and at the temperature from 2200°C to 2500°C. The pressure of the nitrogen gas can be set at from 70 MPa to 200 MPa, for example. To place the β-sialon in such a temperature and pressure environment, it is desirable to use a hot isostatic press furnace.

It is desirable that the average particle diameter D50 of the β-sialon obtained by the manufacturing method according to the present invention is 30 µm or smaller. As specific procedures to allow the β-sialon to have the average particle diameter and the 50% mean area diameter described above, crashing, where the β-sialon is crashed using a crashing device such as crasher, ball mill, oscillating mill, and jet mill, and sieve classification after the crashing treatment are performed.

Change in size of sieve classification can be made by selecting a desired sieve size, 40 µm and 45 µm for example, as required.

In the heat treatment process after the burning process, the β-sialon having undergone the burning process is subjected to heat treatment in an atmosphere of inert gas other than nitrogen at the partial pressure of 10 kPa or lower and at the temperature from 1300°C to 1600°C for two hours or longer but not exceeding ten hours. As an inert gas, argon gas or helium gas are available. In this heat treatment process, the number of electrons excited by external excitation light (electron trap for collecting excited electrons) in the host crystal of the β-sialon can be decreased.

By acid treatment after the heat treatment process, materials other than the β-sialon can be dissolved, and Si that is newly generated as a result of decomposition that occurred during the heat treatment process can be dissolved and removed. Impurities in the β-sialon can thus be decreased.

### (Light-emitting device)

A light-emitting device using the β-sialon according to the second embodiment of the present invention will hereinafter be described in detail.

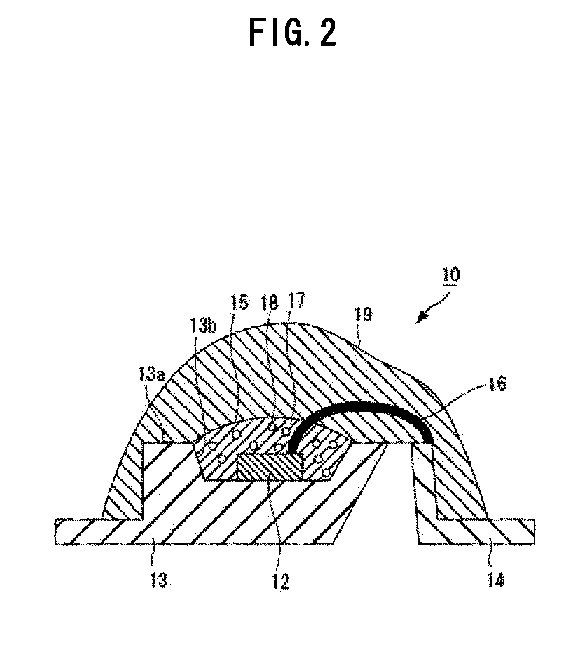

FIG. 2 is a cross-sectional view illustrating the structure of a light-emitting device 10 using the β-sialon according to the second embodiment of the present invention.
The light-emitting device 10 of the present invention includes an LED chip as a luminescent light source 12, a first lead frame 13 to which the luminescent light source 12 is mounted, a second lead frame 14, a wavelength converting member 15 covering the first lead frame 13 and the second lead frame 14 of the luminescent light source 12, a bonding wire 16 for electrically connecting the luminescent light source 12 and the second lead frame 14, and a synthetic resin cap 19 covering them. The wavelength converting member 15 is made of a phosphor 18 and a sealing resin 17 containing the phosphor 18 in dispersed state.

At the top 13a of the first lead frame 13, a concave portion 13b for mounting a diode chip as the luminescent light source 12 is formed. The concave portion 13b has rough funnel shape with its pore diameter increasing upward from the base, and the internal surface of the concave portion 13b functions as a reflection surface. On the bottom surface of this reflection surface, the electrode on the bottom face side of the LED chip 12 is die-bonded. The other electrode formed on the upper surface of the LED chip 12 is connected to the surface of the second lead frame 14 via the bonding wire 16.

As the luminescent light source 12, various LED chips can be used, and LED chips capable of emitting near-ultraviolet to blue light having wavelength falling within a range from 350 nm to 500 nm are especially favorable.

As the phosphor 18 used for the wavelength converting member 5 of the light-emitting device 1, β-sialon, α-sialon, CaAlSiN₃ and YAG elements or mixture of those are available, and the elements to be contained in those include europium (Eu), cerium (Ce), strontium (Sr), and calcium (Ca). By combining the luminescent light source 2 with the wavelength converting member 5, light having high emission intensity can be emitted.

For the phosphor 18 made of β-sialon, the β-sialon represented by general formula Si_{6-z}Al_{z}O_{z}N_{8-z} (0<z≤0.42) is ideal. The 50% mean area diameter of the primary particles of the β-sialon is 5 µm or larger. More preferably, the 50% mean area diameter of the primary particles is 7 µm or larger. It is also preferable that the D50 particle diameter of the secondary particles is 30 µm or smaller.

To control the wavelength of the light from the light-emitting device 10, the β-sialon phosphor can further include Eu doped α-sialon or CaAlSiN₃.

The light-emitting device 10 using the β-sialon of the present invention only has characteristics that by irradiating light from the luminescent light source 12, with near-ultraviolet light or visible light having wavelength of 350 nm or longer but not exceeding 500 nm, in particular, used as an excitation source, green light having its peak within the range from 520 nm to 550 nm can be emitted. Consequently, by using a near-ultraviolet LED chip or blue LED chip as an emission source 12 and the β-sialon of the present invention, and combining them with a single red phosphor, blue phosphor, yellow phosphor, or orange phosphor whose wavelength is 600 nm or longer but not exceeding 700 nm, or mixture of any one of those, white light can be obtained.

Since the light-emitting device 10 of the present invention uses β-sialon 18 high in emission intensity and whose primary particles have large 50% mean area diameter, high emission intensity can be achieved.

### Example

Examples according to the present invention will hereinafter be described in detail by referring to Table 1.

**[Table 1]**

| | | Manufacturing condition | | | | Structure | | Assessment | | |
|---|---|---|---|---|---|---|---|---|---|---|
| | | Burning container (L) | Burning temp. (°C) | Burn ing time (h) | Crashing/Classification process | EBSD50% mean area dia. (µm) | D50 (µm) | Peak emission intensity (%) | CIE chromaticity | |
| | | | | | | | | | x | y |
| Ex. | 1 | 0.4 | 2000 | 10 | No | 5.4 | 21.8 | 207 | 0.361 | 0.618 |
| | 2 | 0.4 | 2000 | 10 | No | 6.0 | 23.5 | 213 | 0.359 | 0.620 |
| | 3 | 0.4 | 2000 | 10 | No | 8.0 | 25.1 | 221 | 0.362 | 0.619 |
| | 4 | 0.4 | 2000 | 10 | Yes | 7.2 | 14.5 | 224 | 0.363 | 0.616 |
| Com. Ex. | 1 | 0.085 | 1800 | 4 | No | 1.2 | 14.3 | 86 | 0.363 | 0.611 |
| | 2 | 0.4 | 1950 | 10 | No | 2.5 | 23.2 | 190 | 0.350 | 0.625 |

### Example 1

### (Burning for obtaining β-sialon)

As raw material mixture, 95.5 mass% α-silicon nitride powder (grade NP-400, Denki Kagaku Kogyo Kabushiki Kaisha, oxygen content: 0.96 mass%, β-phase content: 14.8 mass%), 3.1 mass% aluminum nitride powder (grade F, Tokuyama Corporation, oxygen content: 0.9 mass%), 0.6 mass% aluminum oxide powder (grade TM-DAR, Taimei Chemical Co., Ltd.), and 0.8 mass% europium oxide powder (grade RU, Shin-Etsu Chemical Co., Ltd.) were mixed in order that the z value of the β-sialon after the burning becomes 0.25 to obtain raw material mixture. The compounding ratio for allowing the z value to be 0.25 was calculated without taking the oxygen content in the europium oxide into calculation.

Using a rocking mixer (RM-10, Aichi Electric Co., Ltd.), the raw material mixture was mixed in dry state for 60 minutes, and then the entire mixture was sieved with a 150 µm stainless steel sieve thoroughly to obtain powder raw material mixture for burning phosphors.

90 g of the powder raw material mixture was filled in a lidded cylindrical container having internal capacity of 0.4 L and made of boron nitride (grade N-1, Denki Kagaku Kogyo Kabushiki Kaisha). This powder raw material mixture contained in the container was subjected to heat treatment in the 0.9 MPa pressurized nitrogen atmosphere at 2000°C for 10 hours. The processed material after the heat treatment was crashed lightly, and then sieved with a 45 µm sieve to obtain burned powder mixture.

The burned powder mixture was subjected to powder X-ray diffractometry (referred to as XRD measurement) using Kα ray of Cu, and crystal phase was identified and also the lattice constant of the β-sialon was measured. As a result, a diffraction peak corresponding to near the β-sialon as a first crystal phase, and a plurality of minute diffraction peaks around 2θ=33 to 38° as a second crystal phase are identified. The highest diffraction peak intensity in the second phase was 1% or lower to the diffraction peak intensity of the 101 surface of the β-sialon.

20 g of the burned powder mixture was filled in a lidded cylindrical container made of boron nitride and having the diameter of 6 cm and height of 4 cm (grade N-1, Denki Kagaku Kogyo Kabushiki Kaisha), and heat treatment was conducted in a carbon heater electric furnace in an atmospheric-pressure argon atmosphere at 1450°C for eight hours. The powder obtained by heat treatment was found to have mostly the same property as before the heat treatment, exhibiting no contraction due to sintering, and the entire volume of the powder has passed a 45 µm sieve. As a result of XRD measurement conducted, a slight amount of Si was detected,
The powder obtained by the heat treatment was subjected to 1:1 mixed acid treatment using a 50% hydrofluoric acid solution and 70% nitric acid solution. The color of the suspension consisting of powder and mixed acids changed during the treatment from brownish green to bright green. Then by conducting washing and drying of the suspension, the β-sialon was obtained.

### (50% mean area diameter measured by ESBD)

The 50% mean area diameter of the primary particles of the β-sialon in Example 1 was measured by the EBSD method, using a device with an electronic backscatter diffraction pattern measuring instrument (OIM device, EDAX-TSL) 3 attached to a scanning electron microscope (JSM-7001F, FE-SEM by JEOL Ltd.) 2.

To measure the ESBD 50% mean area diameter, electron beams were irradiated to the β-sialon in Example 1 to cause scattering to occur to the crystal structure and crystal plane, and the scattering patterns were analyzed using software (OIM, Ver. 5.2, EDAX-TSL) to identify crystal orientation of the individual phosphor particles. Furthermore, the particle diameter in individual crystal orientations was measured using the formula (1) shown above, and the 50% mean area diameter of the primary particles was calculated.

The measurement conditions of crystal orientations found by the EBSD method are shown below:

| | |
|---|---|
| Accelerating voltage: | 15 kV |
| Working distance: | 15 mm |
| Sample inclination angle: | 70° |
| Measurement range: | 80 µm × 200 µm |
| Step width: | 0.2 µm |
| Measurement time: | 50 msec/step |
| Number of data points: | Approx. 400,000 points |

### (Image analysis)

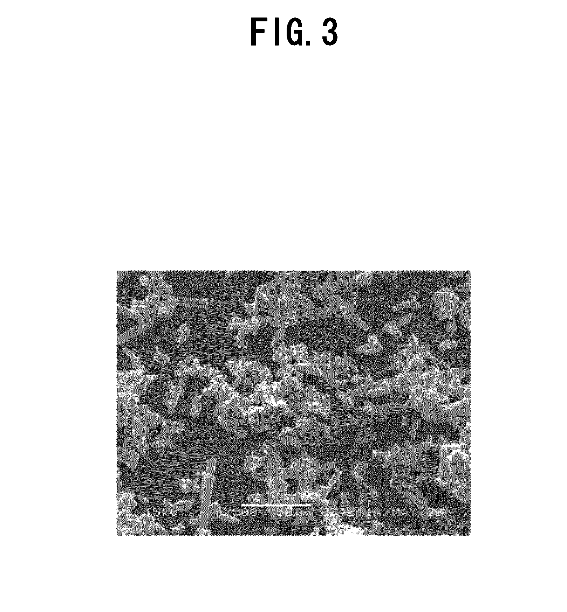

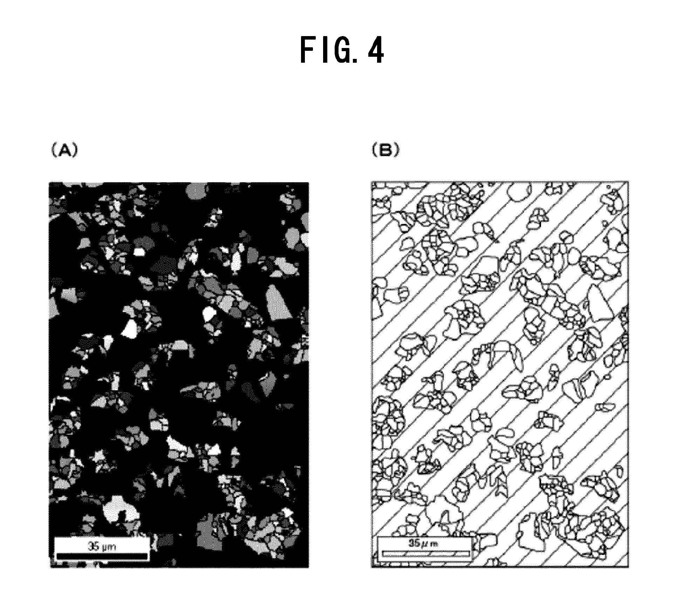

To perform image analysis, the EBSD image shown in FIG. 4 (A) was created from the scanning electron microscopic image shown in FIG. 3 (SEM image, electron accelerating voltage: 15 kV, magnification: 500) of the β-sialon in Example 1, and the figure shown in FIG. 4 (B) was created from the EBSD image shown in FIG. 4 (A).
In FIG. 4 (B), areas other than the one marked with diagonal lines represent primary particles, and the lines shown within each profile represent boundaries of primary particles having different orientations. The higher the number of primary particles provides the higher accuracy in statistical analysis. If the number of primary particles is 3000 or higher, sufficient data for analysis can be obtained. As shown in Table 1, the ESBD 50% mean area diameter of the β-sialon in Example 1 found by this image analysis was 5.4 µm.

### (D50)

The particle distribution of the β-sialon in Example 1 was measured by the laser diffraction scattering method to find D50. The D50 of the β-sialon in Example 1 was 21.8 µm.

### (Peak emission intensity)

To measure the peak fluorescence emission intensity of the β-sialon in Example 1, fluorescence spectra were measured using a spectrophotofluorometer (F4500, Hitachi High-Technologies Corporation). The height of the peak wavelength of the fluorescence spectra when 455 nm blue light was used as excitation light was measured. From this measurement value, the relative value with respect to the height of the peak wavelength measured using YAG: Ce phosphor (P46-Y3, Mitsubishi Chemical Corporation) under the same conditions. As excitation light, dispersed xenon lamp light source was used. The peak emission intensity of the β-sialon in Example 1 was 207%.

### (CIE chromaticity)

CIE (The Commission Internationale de l'Eclairage) chromaticity of fluorescence spectra was found by conducting emission spectrum measurement of the total flux, namely condensed fluorescent lights excited by 455 nm light, using an instantaneous multi-photometry system (MCPD-7000, Otsuka Electronics Co., Ltd.) adopting an integrating sphere (see Non-patent Literature 1). The CIE chromaticity of the β-sialon in Example 1 was X=0.361, Y=0.618.

### Example 2

In order that the z value of the Eu doped β-sialon becomes 0.25 after burning, the composition of the raw material powder mixture was made to be as follows: 95.4 mass% silicon nitride, 2.3 mass% aluminum nitride, 1.6 mass% aluminum oxide powder, and 0.8 mass% europium oxide. The conditions other than the above were the same as those in Example 1.

The 50% mean area diameter of the primary particles of the β-sialon in Example 2 was 6.0 µm, and its D50 was 23.5 µm. The peak emission intensity was 213%, and the CIE chromaticity was X=0.359,
Y=0.620.

### Example 3

In order that the z value of the Eu doped β-sialon becomes 0.25 after burning, the composition of the raw material powder mixture was made to be as follows: 95.4 mass% silicon nitride, 2.8 mass% aluminum nitride, 1.0 mass% aluminum oxide powder, and 0.8 mass% europium oxide. The conditions other than the above were the same as those in Example 1.

The 50% mean area diameter of the primary particles of the β-sialon in Example 3 was 8.0 µm, and its D50 was 25.1 µm. The peak emission intensity of the β-sialon in Example 3 was 221%, and its CIE chromaticity was X=0.362, Y=0.619.

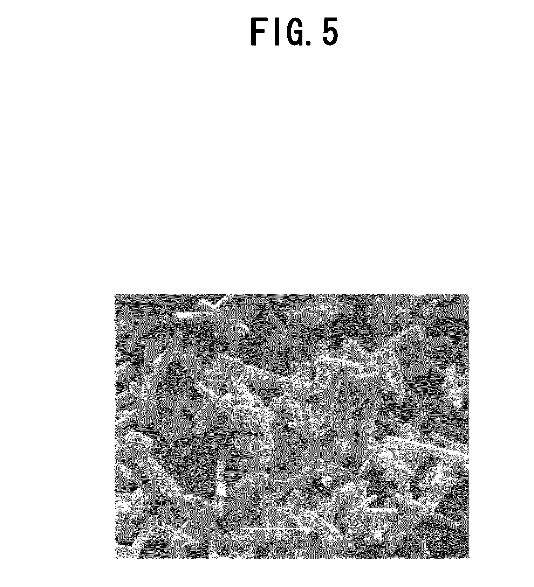

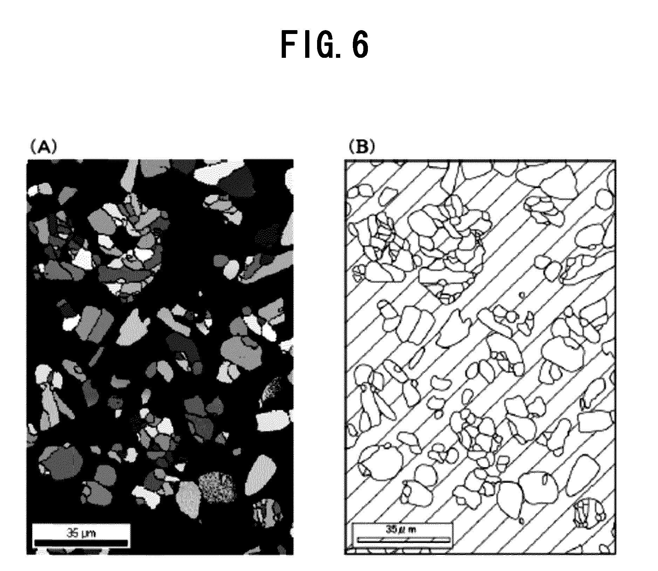

FIG. 5 is a scanning electron microscopic image (SEM: electron accelerating voltage; 15 kV, magnification; 500) of the β-sialon in Example 3, FIG. 6 (A) is an EBSD image created from the SEM image, and FIG. 6 (B) is a drawing created from the EBSD image. As in the case of FIG. 4 (B), the areas other the one marked with diagonal lines in FIG. 6 (B) represent primary particles, and the lines shown within each profile represent the boundaries of primary particles having different orientations.

### Example 4

The β-sialon in Example 4 was produced under the same conditions as Example 2, except that the β-sialon in Example 2 was crashed using an ultrasonic jet crasher (PJM-80, Nippon Pneumatic Mfg. Co., Ltd.). Example 4 is a manufacturing method wherein a crashing/classification process was further added to the manufacturing process shown in Example 2.

The 50% mean area diameter of the primary particles of the β-sialon in Example 4 was 7.2 µm, and its D50 was 14.5 µm. The peak emission intensity of the β-sialon in Example 4 was 224%, and its CIE chromaticity was X=0.363, Y=0.616.

### (Comparative Example 1)

The β-sialon in Comparative Example 1 was manufactured under the same conditions as Example 1, except that the volume of the burning vessel in Example 1 was changed to 0.085 L, and that the heat treatment process conditions were as follows: at the temperature of 1800°C for four hours.

The 50% mean area diameter of the primary particles of the β-sialon in Comparative Example 1 was 1.2 µm, and its D50 was 14.3 µm. The peak emission intensity of the β-sialon in Comparative Example 1 was 86%, and its CIE chromaticity was X=0.363, Y=0.611.

### (Comparative Example 2)

The β-sialon in Comparative Example 2 was manufactured under the same conditions as Example 1, except that the burning temperature in Example 1 was changed to 1950°C.

The 50% mean area diameter of the primary particles of the β-sialon in Comparative Example 2 was 2.5 µm, and its D50 was 23.2 µm. The peak emission intensity of the β-sialon in Comparative Example 2 was 190%, and its CIE chromaticity was X=0.353, Y=0.625.

From Examples 1 to 4 and Comparative Examples 1 and 2, it was found that the 50% mean area diameter of the primary particles of the β-sialon does not become 5 µ or larger, and consequently the peak emission intensity remains low, unless the burning temperature exceeds 1950°C, and the burning time is 10 hours or longer.

Namely, the D50 particle diameter of the secondary particles of the β-sialon in Examples 1 to 4 is approximately the same as or smaller than those of Comparative Example 2, whereas the 50% mean area diameter of the primary particles is twice as large or larger. In other words, the β-sialon of the present invention is formed with primary particles having large particle size combined. Consequently, the amount of contact interface among primary particles is small.

Since large contact interface among primary particles adversely affects the peak emission intensity, the smaller the contact interface, the better.

In the present invention, burning conditions allowing the 50% mean area diameter only to become 5 µ or larger without enlarging the particle size of the secondary particles of the β-sialon were found.

The inventors also found that the amount of contact interface of primary particles affects not only the peak emission intensity but also the absorption of different colors of other phosphors. The β-sialon of the present invention provides the effect of improving the emission intensity of light-emitting devices when used in combination with other phosphors. This effect will be detailed in Example 5.

### Example 5

The light-emitting device using the β-sialon in Example 5 will hereinafter be described in detail by referring to FIG. 2.
The structure of the light-emitting device 10 according to Example 5 of the present invention is the same as the one shown in FIG. 2. The phosphor 18 is a mixture of the β-sialon of Example 4 and Eu phosphor of Ca-α sialon having the composition of Ca_{0.66}Eu_{0.04}Si_{9.9}Al_{2.1}O_{0.7}N_{15.3}. The peak emission wavelength of the Eu phosphor of Ca-α sialon: was 585 nm, and the emission efficiency of this phosphor under 450 nm excitation was 60%.

The phosphor 18 was mixed in the sealing resin 17 as follows:
The phosphor 18 was subjected to silane coupling treatment in advance using a silane coupling agent (KBE402, Shin-Etsu Chemical Co., Ltd.), and the phosphor 18 having undergone silane coupling treatment was kneaded into an epoxy resin (NLD-SL-2101, Sanyu Rec Co., Ltd.) as the sealing agent 17.

As a luminescent light source 12, a blue LED chip having emission wavelength of 450 nm was used.

### (Comparative Example 3)

The light-emitting device in Comparative Example 3 was achieved as same as Example 5, except that the β-sialon in Example 4 used as phosphor 18 in the light-emitting device 10 in Example 5 was changed to the β-sialon of Comparative Example 1.

The light-emitting device 10 of Example 5 and the light-emitting device of Comparative Example 3 were made to emit light under the same conditions, and their central luminance and CIE chromaticity (CIE1931) were measured. Comparison of the central luminance conducted using a white light-emitting device having chromaticity coordinate (x, y) of (0.31, 0.32) revealed that the luminance of Example 5 was 1.49 times brighter than that of Comparative Example 3.

The embodiments of the present invention are not limited to those described above, but various variation are allowed within the scope of the claim, and they are included in the scope of the present invention. For example, the color of the light-emitting device 10 can be changed into those other than white, incandescent bulb color for example, by further adding phosphors of different emission wavelengths emitting yellow and red lights to the phosphor 18 of the β-sialon and by changing their compounding ratio.

### Industrial Applicability

The β-sialon according to the present invention is applicable as a phosphor for LED.
In addition, the light-emitting device according to the present invention can be used for lighting systems, LC panel backlight, light source of the projectors for image display, etc.

### Reference Signs List

| | |
|---|---|
| 1: | Device used for the EBSD method |
| 2: | Scanning electron microscope |
| 2A: | Lens tube |
| 2B: | Stage |
| 2C: | Stage control unit |
| 2D: | Electron scanning unit |
| 2E: | Control computer |
| 3: | Electronic backscatter diffraction pattern measuring instrument |
| 4: | Sample |
| 5: | Electron beam |
| 6: | Backscattered electron |
| 7: | Fluorescent screen |
| 8: | Camera |
| 10: | Light-emitting device |
| 12: | Luminescent light source (LED chip) |
| 13: | First lead frame |
| 13a: | Top part |
| 13b: | Concave portion |
| 14: | Second lead frame |
| 15: | Wavelength converting member |
| 16: | Bonding wire |
| 17: | Sealing resin |
| 18: | Phosphor (β-sialon) |
| 19: | Cap |

## Claims

1. A method for manufacturing β-sialon, comprising: a mixing process wherein at least one of aluminum oxide and silicon oxide, silicon nitride, aluminum nitride, and europium compound are mixed;
a burning process wherein the mixture having undergone the mixing process is heated at the temperature higher than 1950°C but not exceeding 2200°C for 10 hours or longer; and
a heat treatment process wherein heat treatment is conducted after the burning process at the temperature from 1300°C to 1600°C in an atmosphere of inert gas other than nitrogen and at the partial pressure of 10 kPa or lower.

2. The method for manufacturing β-sialon as set forth in claim 1, wherein the burning process is conducted condition at the temperature from 2000°C to 2200°C for 10 hours or longer.

3. Eu doped β-sialon represented by general formula Si_{6-z}Al_{z}O_{z}N_{8-z} (0<z≤0.42), wherein the 50% mean area diameter of primary particles of the Eu doped β-sialon is 5 µm or larger.

4. The Eu doped β-sialon as set forth in claim 3, wherein the 50% mean area diameter of the primary particles of the Eu doped β-sialon is 7 µm or larger.

5. The Eu doped β-sialon as set forth in claim 3 or 4, wherein the D50 particle diameter of secondary particles of the Eu doped β-sialon is 30 µm or smaller.

6. A light-emitting device, comprising: a luminescent light source; and a wavelength converting member,
wherein the wavelength converting member includes a phosphor that absorbs near-ultraviolet to blue light generated from the luminescent light source and generates fluorescent light, and
the phosphor is the phosphor as set forth in one of claims 3 to 5.

7. The light-emitting device as set forth in claim 6, wherein the luminescent light source is an LED chip that generates light having wavelength that fall within the range from 350 nm to 500 nm.

8. A light-emitting device, wherein the phosphor used for the light-emitting device as set forth in claim 7 is a phosphor having the phosphor as set forth in claim 3 and Eu doped α-sialon.

9. The light-emitting device as set forth in claim 8, wherein the Eu doped α-sialon is Ca-α-sialon.
